# EUROPÄISCHE PATENTSCHRIFT

(11) **EP 1 121 841 B1**
(45) Veröffentlichungstag und Bekanntmachung des Hinweises auf die Patenterteilung: **14.05.2003**
(21) Anmeldenummer: 99957847.9
(22) Anmeldetag: 20.09.1999
(51) Int. Cl.: H05K 7/14, H05K 9/00

(54) **VORRICHTUNG ZUR AUFNAHME VON ELEKTRISCHEN FLACHBAUGRUPPEN, INSBESONDERE BAUGRUPPENTRÄGER**
DEVICE FOR RECEIVING ELECTRICAL PRINTED CIRCUIT MODULES, ESPECIALLY A SUBRACK
DISPOSITIF SERVANT A RECEVOIR DES MODULES ELECTRIQUES PLATS, NOTAMMENT DES SUPPORTS DE MODULES

(30) Priorität: 01.10.1998 DE 29817536 U; 09.10.1998 DE 19846628
(43) Veröffentlichungstag der Anmeldung: 08.08.2001
(73) Patentinhaber: Rittal Electronic Systems GmbH & Co. KG, 90542 Eckental (DE)
(72) Erfinder: KÖRBER, Werner, D-91282 Betzenstein (DE); SCHAFFER, Kurt-Michael, D-90542 Eckental (DE); BILLENSTEIN, Ernst, D-91593 Burgbernheim (DE); KURRER, Siegfried, D-90449 Nürnberg (DE)
(74) Vertreter: Fleck, Hermann-Josef, Dr.-Ing.
(86) Internationale Anmeldenummer: DE9903002
(87) Internationale Veröffentlichungsnummer: WO00021348

(56) Entgegenhaltungen:
- EP-A- 0 727 853
- WO-A-92/16093
- DE-C- 19 644 418
- DE-U- 9 316 539
- DE-U- 29 604 597
- DE-U- 29 719 220
- "GEHÄUSE Wandelbare Versionen" ELEKTROTECHNIK, Bd. 69, Nr. 21, 16. Dezember 1987 (1987-12-16), Seiten 40+43-., XP002131950 Würzburg DE

## Beschreibung

Die Erfindung betrifft eine Vorrichtung zur Aufnahme von elektrischen Flachbaugruppen. Dabei enthält eine Flachbaugruppe zumindest eine mit elektrischen Bauelementen bestückte Leiterplatte, welche in aller Regel zusätzlich mit einer Frontplatte und zumindest einem Steckverbinder an einer Rückseite ausgerüstet ist. Eine Aufnahmevorrichtung soll zumindest eine geordnete mechanische Plazierung derartiger Flachbaugruppen in einem gehäuseartigen Gestell ermöglichen. Bei entsprechender Ausführung kann eine derartige Aufnahmevorrichtung auch Abschirmungszwecke unterschiedlicher Art erfüllen, z.B. die enthaltenden Flachbaugruppen gegen die äußere Einwirkung von Schmutz und Feuchtigkeit schützen bzw. eine Abstrahlung von elektromagnetischen Störungen aus dem Inneren verhindern.

In vielen Fällen werden Aufnahmevorrichtungen der oben genannten Art in Form von sogenannten Baugruppenträgern ausgeführt. Dabei handelt es sich um standardisierte Aufbauten mit vereinheitlichten Maßen und aufeinander abgestimmten Komponenten. Eine bekannte Bauweise ist z.B. die sogenannte 19 Zoll Einbautechnik.

Eine Aufnahmevorrichtung der vorliegenden Art weist zumindest ein Seitenteil und zumindest ein Abdeckteil auf. Häufig weist der Rahmen einer bevorzugten, in Form eines Baugruppenträgers ausgeführten Aufnahmevorrichtung ein linkes und ein rechtes Seitenteil auf, welche über zwei Paare von oberen und unteren Querverbindungsschienen an Front- und Rückseite miteinander verbunden sind. Die Ober- und Unterseiten eines derartigen Baugruppenträgers können über Abdeckteile verschlossen werden. Die Rückseite kann durch eine sogenannte Rückwandplatine verschlossen sein, welche auf der Innenseite mit Steckverbindergegenstücken und einem Rückwandbus belegt ist. Die Frontseite dient schließlich zur Einschieben von elektrischen Flachbaugruppen, welche in der Regel senkrecht parallel nebeneinander liegend im Inneren des Baugruppenträgers plaziert sind.

Die Verbindung eines Abdeckteiles mit einem Seitenteil, welche vielfach eine sogenannte Eckstoßverbindung darstellt, muß verschiedenen Anforderungen genügen. Zum einem muß diese mechanisch stabil sein, sollte aber andererseits konstruktiv nicht aufwendig sein und eine möglichst einfach Montage ermöglichen. Darüber hinausgehend können weitere Anforderungen an diese Verbindung darin liegen, daß auch eine ausreichende Dichtigkeit z.B. gegenüber einem Durchtritt von elektromagnetischen Wellen gewährleistet ist.

Zur Verbindung eines Abdeckteiles mit einem Seitenteil ist es z.B. aus dem Deutschen Gebrauchsmuster DE 297 19 220 U1 bekannt, eine Feder einzusetzen, welche eine klemmende Befestigung sowohl eines Abdeckteiles als auch eines Seitenteiles ermöglicht.

Aus dem Deutschen Patent DE 196 44 418 C1 sind Befestigungselemente in Form von Winkelträgern aus federelastischem Stahlblech bekannt. Diese weisen zwei Winkelschenkel auf, welche annähernd einen Winkel von 90 Grad zueinander einnehmen. Der eine Winkelschenkel ermöglicht eine klemmende Halterung z.B. eines Abdeckteiles, während der andere Winkelschenkel über eine Schraubenaufnahme mit z.B. einem Seitenteil verschraubbar ist.

Ferner ist es aus dem Deutschen Gebrauchsmuster DE 296 04 597 U1 bekannt, zur eckstoßartigen Verbindung eines Seiten- und eines Abdeckteiles separate, innenliegende Auflageelemente einzusetzen. Diese können bevorzugt die Form von länglichen Auflageklötzen aufweisen. Diese sind bevorzugt mit einem Abdeckteil verschraubt und liegen zur Abstützung auf vorspringenden Noppen eines Seitenteiles auf.

Ferner ist aus der EP 0 727 853 A1 ein Verbindungssystem mit Einklinkungen für gewindeformende Schrauben als Verbindungselemente bekannt, bei welchem die Steckverbindungen Aufnahmen und komplementär ausgebildete Eingriffselemente aufweisen, und die Aufnahmen insbesondere in Seitenkanten des Boden- und Deckenteils und die Eingriffselemente in den Seitenteilen zur Verbindung mit dem Boden- und/oder Deckenteil ausgebildet sind.

Diese bekannten Verbindungen eines Abdeckteiles mit einem Seitenteil weisen den Machteil auf, daß in allen Fällen sepaRate Bauteile in Form von Winkelträgern, Auflageelementen und dergleichen benötigt werden. Vielfach müssen die Bauteile mit Hilfe von weiteren Elementen, insbesondere Schrauben, an zumindest einem Abdeck- oder Seitenteil angebracht werden.

Der Erfindung liegt die Aufgabe zu Grunde, eine Verbindung zwischen einem Seiten- und einem Abdeckteil einer Aufnahmevorrichtung für Flachbaugruppen so auszugestalten, daß möglichst keine zusätzlichen Bauelemente benötigt werden.

Die Aufgabe gelöst mit der im Anspruch 1 angegebenen Vorrichtung. Vorteilhafte Ausgestaltungen der Erfindung sind in den Unteransprüchen angegeben.

Die Erfindung und der Vorteile werden anhand der in den nachfolgend kurz angeführten Figuren dargestellten Ausführungsbeispiele weiter erläutert. Dabei zeigt
- FIG 1: eine perspektivische Seitenansicht auf eine beispielhafte, gemäß der Erfindung gestaltete und in Form eines Baugruppenträgers ausgeführte Aufnahmevorrichtung.
- FIG 2: einen perspektivischen Teilausschnitt einer beispielhaften weiteren Ausfuhrungsform der Erfindung, wobei ein Abdeckteil und eine Querverbindungsschiene einteilig ausgeführt sind, und
- FIG 3: einen perspektivischen Teilausschnitt einer beispielhaften weiteren Ausführungsform der Erfindung, wobei ein Abdeckteil, und eine Querverbindungsschiene ebenfalls einteilig ausgeführt sind.

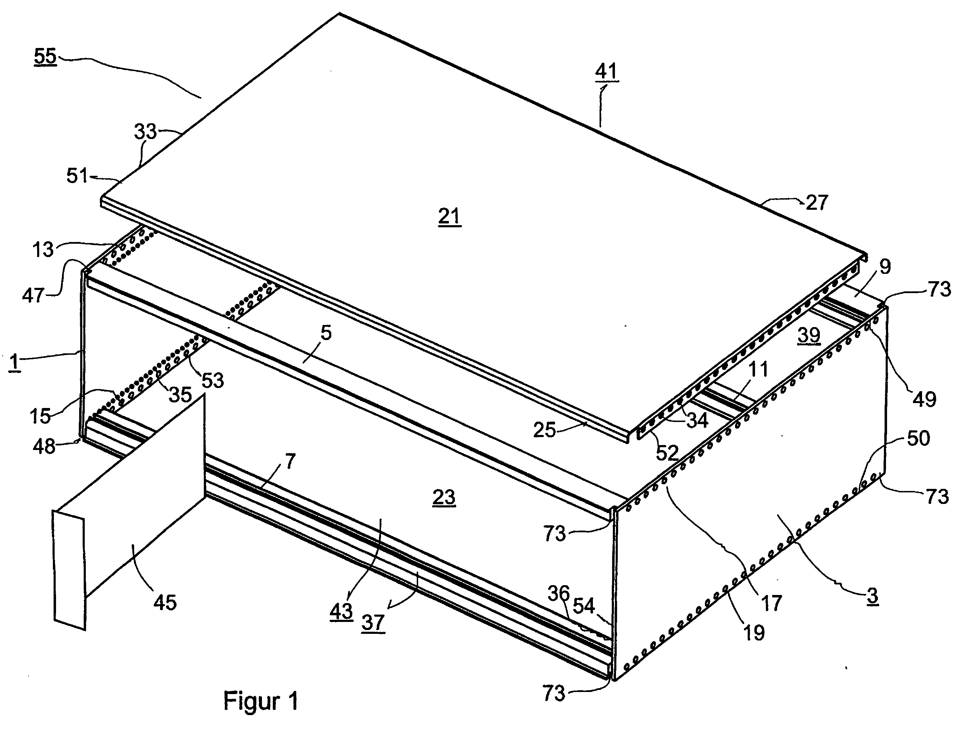

Figur 1 zeigt beispielhaft in einer perspektivischen Seitenansicht eine in Form eines Baugruppenträgers ausgeführte und gemäß der Erfindung gestaltete Aufnahmevorrichtung für Flachbaugruppen. Der Baugruppenträger 55 weist ein linkes und rechtes Seitenteil 1,3 auf, welches jeweils vorteilhaft die Form eines bevorzugt ebenen Seitenwandbleches aufweist. Die Seitenteile sind im Bereich der Ecken über vier Querverbindungsschienen miteinander verbunden, wobei sich ein erstes Paar von oberen und unteren Querverbindungsschienen 5,7 an der Frontseite 37, und ein zweites Paar von oberen und untere Querverbindungsschienen 9,11 an der Rückseite 39 des Baugruppenträgers 55 befindet. An der Frontseite 37 ist beispielhaft eine elektrische Flachbaugruppe 45 senkrecht stehend symbolisch dargestellt, welche in das Innere des Baugruppenträgers einschiebbar ist.

Mit den beiden oberen bzw. unteren Querverbindungsschienen 5,9 bzw. 7,11 wird jeweils eine Oberseite 41 bzw. eine Unterseite 43 des Baugruppenträgers aufgespannt. Diese sind über ein oberes bzw. unteres Abdeckteil 21,23 verschließbar, wobei im Beispiel der Figur 1 das untere Abdeckteil 21 in einem aufgesetzten und das obere Abdeckteil 23 in einem abgehobenen Zustand dargestellt sind.

Gemäß der Erfindung weist ein Seitenteil an zumindest einer ersten Kante eine Reihe von Ausnehmungen und ein Abdeckteil an zumindest einer zweiten Kante eine Reihe von Erhebungen auf. Die Kanten sind dabei so zueinander ausgerichtet, daß Ausnehmungen und Erhebungen zur Verbindung eines Seiten- und Abdeckteiles ineinander greifen. Eine derartige Ausführung ist im Beispiel der Figur 1 dargestellt und wir nachfolgend noch näher erläutert werden. Selbstverständlich kann gemäß einer anderen, in den Figuren nicht weiter dargestellten Ausführung in umgekehrter Weise ein Seitenteil an zumindest einer ersten Kante eine Reihe von Erhebungen und ein Abdeckteil an zumindest einer zweiten Kante eine Reihe von Ausnehmungen aufweisen.

Im Beispiel der Figur 1 weist das linke bzw. rechte Seitenteil 1 bzw. 3 jeweils an den oberen und unteren Längskanten 47 und 48 bzw. 49 und 50 jeweils eine obere und untere Reihe 13 und 15 bzw. 17 und 19 von Ausnehmungen auf. Diese sind im Beispiel der Figur 1 in Form von Bohrungen ausgeführt.

Ferner weist im Beispiel der Figur 1 das obere bzw. untere Abdeckteil 21 bzw. 23 jeweils an den linken und rechten Längskanten 51 und 52 bzw. 53 und 54 jeweils eine linke und rechte Reihe 33 und 34 bzw. 35 und 36 von Erhebungen auf. Diese sind im Beispiel der Figur 1 in Form von Prägenoppen ausgeführt.

Der Vorteil der erfindungsgemäßen Ausführung wird darin gesehen, daß aufgrund des wechselseitigen Eingriffes von Erhebungen an den Längskanten eines Seiten- bzw. Abdeckteiles in entsprechend positionierte Ausnehmungen an korrespondierenden Längskanten eines Abdeck- bzw. Seitenteiles eine mechanisch stabile Verbindung dieser Teile hergestellt werden kann, ohne daß separate Befestigungsteile benötigt werden. Ferner ist die Montage z.B. eines Abdeckteiles auf einem Baugruppenträger z.B. der im Beispiel der Figur 1 dargestellten Art, welcher zwei, über Querverbindungsschienen verbundene Seitenteile aufweist, auf einfache Weise ohne Werkzeuge durch einfaches Aufrasten möglich. Die beim Ineinandergreifen von Erhebungen und Ausnehmungen durch eine Art Verràstung entstehende Klemmverbindung stellt eine gut ausreichende Halterung eines Abdeckteiles auf der Ober- bzw. Unterseite eines Baugruppenträgers dar.

Insbesondere dann, wenn alle Teile einer derartigen Aufnahmevorrichtung, d.h. Seitenteile, Abdeckteile und gegebenenfalls auch Querverbindungsschienen, zusätzlich aus Werkstoffen bestehen, welche zumindest elektrisch leitende Oberflächen aufweisen, so kann neben einer mechanischen auch eine elektrisch leitende Verbindung zwischen den Teilen hergestellt werden. Ein derartiger Baugruppenträger weist in einem solchen Fall auch elektrisch abschirmende Eigenschaften auf. Besonders gut leitende Übergänge zwischen Seiten- und Abdeckteilen, und damit besonders gute Abschirmwirkungen, können mit Erhebungen in Form von Prägenoppen und mit Ausnehmungen in Form von Bohrungen erzielt werden.

Die Abschirmwirkung kann weiter dadurch verbessert werden, daß die Längskanten 51 und 52 bzw. 53 und 54 des oberen bzw. unteren Abdeckteiles 21 bzw. 23 vorteilhaft die Form von abgewinkelten Kontaktschenkeln aufweisen. Eine derartige Ausführung ist im Beispiel der Figur 1 bereits dargestellt. Das dort gezeigte obere Abdeckteil 21 weist zusätzlich an den vorderen und hinteren Querseiten weitere vordere und hintere, bevorzugt abgewinkelte Kontaktschenkel 25,27 auf. Diese kontaktieren im aufgesetzten Zustand des Abdeckteiles 21 bevorzugt mit den Innenkanten der vorderen und hinteren Querverbindungsschiene 5,9. Ein derart ausgeführtes Abdeckteil 21 kann auch als ein Abschirmblech bezeichnet werden. Die abgewinkelten Kontaktschenkel 25,27 können zusätzlich mit Kontaktfederstreifen belegt sein.

Insbesondere dann, wenn die Längskanten 47,48 des linken Seitenteiles 1 und die Längskanten 49,50 des rechten Seitenteiles 3 mit Ausnehmungen versehen sind, so können die Ausnehmungen auch zur Befestigung von Querverbindungsschienen mit den Seitenteilen verwendet werden. Im Beispiel der Figur 1 können die beispielhaft vier Querverbindungsschienen 5,9,7,11 jeweils an deren Stirnseiten 72 mit Hilfe von Schraubverbindungen befestigt werden, welche durch ausgewählte Ausnehmungen hindurchgreifen.

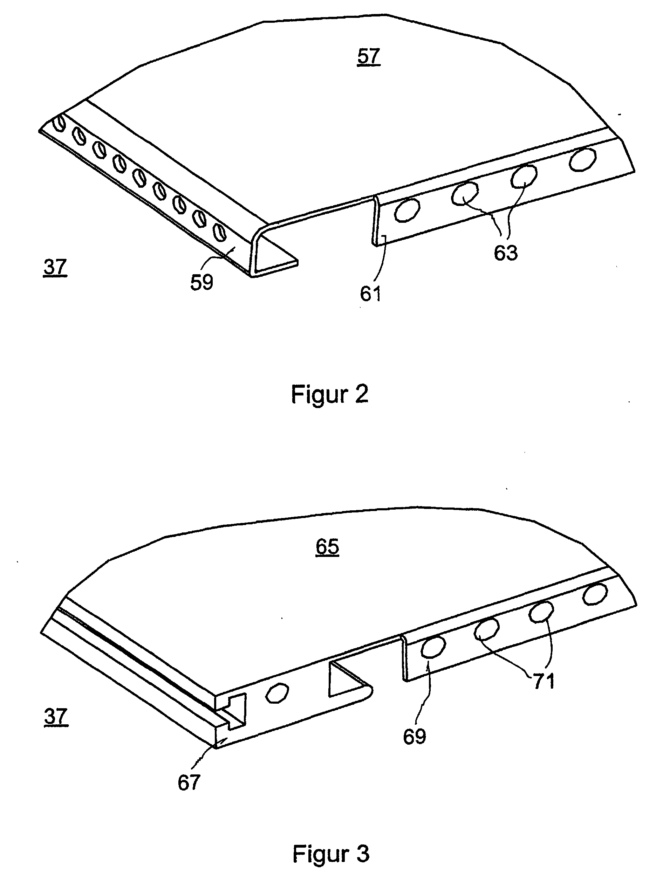

Gemäß einer weiteren Ausführungsform der Erfindung können Abdeckteile und Querverbindungsschienen auch einteilig ausgeführt sei, d.h. konstruktiv eine Einheit bilden. In den Figuren 2 und 3 sind exemplarisch zwei mögliche Ausführungen dargestellt.

Dabei kann das in Figur 2 dargestellte obere Abdeckteil 57 als eine funktionelle Verschmelzung des oberen Abdeckteiles 21 mit der vorderen, oberen Querverbindungsschiene 5 von Figur 1 angesehen werden. Einerseits ist die rechte Längskante 61 gemäß der Erfindung vorteilhaft als ein abgewinkelter Kontaktschenkel ausgebildet und mit einer Reihe 63 von Erhebungen in Form von nach außen gerichteten Prägenoppen versehen. Andererseits ist die der Frontseite 37 eines Baugruppenträgers zugewandte Querkante 59 als integrierte Querverbindungsschiene ausgebildet. Im dargestellten Beispiel ist die Querkante 59 hierzu zweifach abgekantet und weist eine Lochreihe auf. Über diese Lochreihe können Flachbaugruppen bevorzugt über deren Frontplatten befestigt werden.

Das schließlich in der Figur 3 dargestellte obere Abdeckteil 65 kann als eine funktionelle und konstruktive Verschmelzung des oberen Abdeckteiles 21 mit der vorderen, oberen Querverbindungsschiene 5 von Figur 1 angesehen werden. Einerseits ist auch hier die rechte Längskante 69 gemäß der Erfindung vorteilhaft als ein abgewinkelter Kontaktschenkel ausgebildet und mit einer Reihe 71 von Erhebungen in Form von nach außen gerichteten Prägenoppen versehen. Andererseits ist die der Frontseite 37 eines Baugruppenträgers zugewandte Querkante 67 als integrierte Querverbindungsschiene ausgebildet. Im dargestellten Beispiel ist die Querkante 67 in Form eines Stranggußprofiles ausgeführt und weist im wesentlichen die gleiche Querschnittsform wie die Querverbindungsschiene 5 im Beispiel der Figur 1 auf.

## Patentansprüche

1. Vorrichtung zur Aufnahme von elektrischen Flachbaugruppen (45), insbesondere ein Baugruppenträger (55), mit zumindest einem Seitenteil (1;3) und zumindest einem Abdeckteil (21;23), wobei
a) ein Seitenteil (1;3) an zumindest einer ersten Kante (47,48;49,50) eine Reihe von Bohrungen (13,15;17,19) oder Erhebungen aufweist,
b) ein Abdeckteil (21;23) an zumindest einer zweiten Kante (51,52;53,54) eine Reihe von Erhebungen (33,34;35,36) oder Bohrungen aufweist, und wobei
c) eine erste und zweite Kante (49,52) so zueinander ausgerichtet sind, daß Bohrungen (17) und Erhebungen (34) zur Verbindung eines Seiten- und Abdeckteiles (3;21) ineinandergreifen.

2. Vorrichtung nach Anspruch 1, wobei die Erhebungen (33,34;35,36) Prägenoppen sind.

3. Vorrichtung nach einem der vorangegangenen Ansprüche, wobei ein Seitenteil (1;3) die Form eines Seitenwandbleches aufweist.

4. Vorrichtung nach Anspruch 3, wobei ein Seicenwandblech eben ist.

5. Vorrichtung nach einem der vorangegangenen Ansprüche, wobei an einem Seitenteil (1;3) eine Reihe von Bohrungen (13,15;17,19) oder Erhebungen entlang einer ersten Längskante (47,48;49,50) angeordnet ist, insbesondere einer oberen und/oder unteren Längskante.

6. Vorrichtung nach einem der vorangegangenen Ansprüche, wobei ein Abdeckteil (21;23) die Form eines Abschirmbleches aufweist.

7. Vorrichtung nach einem der vorangegangenen Ansprüche, wobei an einem Abdeckteil (21;23) eine Reihe von Erhebungen (33,34;35,36) oder Bohrungen entlang einer zweiten Längskante (51,52;53,54) angeordnet ist, insbesondere einer linken und/oder rechten Längskante.

8. Vorrichtung nach Anspruch 7, wobei eine zweite Längskante (51,52;53,54) an einem Abdeckteil (21;23) die Form eines abgewinkelten Kontaktschenkels aufweist.

9. Vorrichtung nach einem der vorangegangenen Ansprüche, mit
a) zumindest einer insbesondere vordere und/oder hintere Querverbindungsschiene (5,9;7,11) an einer Ober- und/oder Unterseite (41,43); und wobei
b) ein Abdeckteil (57,65) und zumindest eine Querverbindungsschiene (59,67) einteilig ausgeführt sind.

10. Vorrichtung nach einem der vorangegangenen Ansprüche aus einem Werkstoff mit zumindest elektrisch leitenden Oberflächen.

## Claims

1. Apparatus for holding electrical printed circuit board assemblies (45), in particular a mounting rack (55), having at least one side part (1; 3) and at least one cover part (21; 23), in which
a) a side part (1; 3) has a row of holes (13, 15; 17, 19) or projections on at least one first edge (47, 48; 49, 50),
b) a cover part (21; 23) has a row of projections (33, 34; 35, 36) or holes on at least one edge (51, 52; 53, 54), and in which
c) a first and a second edge (49, 52) are aligned with respect to one another such that holes (17) and projections (34) engage in one another in order to connect a side part and a cover part (3; 21).

2. Apparatus according to Claim 1, in which the projections (33, 34; 35, 36) are embossed studs.

3. Apparatus according to one of the preceding claims, in which a side part (1; 3) is in the form of a side wall plate.

4. Apparatus according to Claim 3, in which one side wall plate is planar.

5. Apparatus according to one of the preceding claims, in which a row of holes (13, 15; 17, 19) or projections is arranged along a first longitudinal edge (47, 48; 49, 50), in particular an upper and/or lower longitudinal edge, on one side part (1; 3).

6. Apparatus according to one of the preceding claims, in which a cover part (21; 23) is in the form of a screening plate.

7. Apparatus according to one of the preceding claims, in which a row of projections (33, 34; 35, 36) or holes is arranged along a second longitudinal edge (51, 52; 53, 54), in particular a left-hand and/or right-hand longitudinal edge, on a cover part (21; 23).

8. Apparatus according to Claim 7, in which a second longitudinal edge (51, 52; 53, 54) on a cover part (21; 23) has the form of an angled contact limb.

9. Apparatus according to one of the preceding claims, having
a) at least one in particular front and/or rear transverse connecting rail (5, 9; 7, 11) on an upper face and/or lower face (41, 43); and in which
b) a cover part (57, 65) and at least one transverse connecting rail (59, 67) are formed integrally.

10. Apparatus according to one of the preceding claims, composed of a material having at least electrically conductive surfaces.

## Revendications

1. Dispositif servant à recevoir des modules électriques plats (45), notamment un support de modules (55), comprenant au moins une partie latérale (1 ; 3) et au moins une partie de recouvrement (21 ; 23), où
a) une partie latérale (1 ; 3) présente, sur au moins un premier bord (47, 48 ; 49, 50), une rangée d'alésages (13, 15 ; 17, 19) ou de rehaussements,
b) une partie de recouvrement (21 ; 23) présente, sur au moins un deuxième bord (51, 52 ; 53, 54), une rangée de rehaussements (33, 34 ; 35, 36) ou d'alésages, et où
c) un premier et un deuxième bords (49, 52) sont orientés l'un par rapport à l'autre de telle sorte que des alésages (17) et des rehaussements (34) viennent en engagement mutuel pour connecter une partie latérale et une partie de recouvrement (3 ; 21).

2. Dispositif selon la revendication 1, dans lequel les rehaussements (33, 34 ; 35, 36) sont des noppes de gaufrage.

3. Dispositif selon l'une quelconque des revendications précédentes, dans lequel une partie latérale (1 ; 3) présente la forme d'une tôle de paroi latérale.

4. Dispositif selon la revendication 3, dans lequel une tôle de paroi latérale est plane.

5. Dispositif selon l'une quelconque des revendications précédentes, dans lequel une rangée d'alésages (13, 15 ; 17, 19) ou de rehaussements est disposée sur une partie latérale (1 ; 3) le long d'un premier bord longitudinal (47, 48 ; 49, 50), en particulier un bord longitudinal supérieur et/ou inférieur.

6. Dispositif selon l'une quelconque des revendications précédentes, dans lequel une partie de recouvrement (21 ; 23) présente la forme d'une tôle de blindage.

7. Dispositif selon l'une quelconque des revendications précédentes, dans lequel une rangée de rehaussements (33, 34 ; 35, 36) ou d'alésages est disposée sur une partie de recouvrement (21 ; 23) le long d'un deuxième bord longitudinal (51, 52 ; 53, 54), en particulier un bord longitudinal gauche et/ou droit.

8. Dispositif selon la revendication 7, dans lequel un deuxième bord longitudinal (51, 52 ; 53, 54) sur une partie de recouvrement (21 ; 23) présente la forme d'une branche de contact coudée.

9. Dispositif selon l'une quelconque des revendications précédentes, comprenant
a) au moins un rail de liaison transversal en particulier avant et/ou arrière (5, 9 ; 7, 11) sur un côté supérieur et/ou inférieur (41, 43); et où
b) une partie de recouvrement (57, 65) et au moins un rail de liaison transversal (59, 67) sont réalisés d'une seule pièce.

10. Dispositif selon l'une quelconque des revendications précédentes, constitué d'un matériau avec au moins des surfaces conductrices de l'électricité.
